# EUROPEAN PATENT SPECIFICATION

(11) **EP 3 819 923 B1**
(45) Date of publication and mention of the grant of the patent: **01.01.2025**
(21) Application number: 19831125.0
(22) Date of filing: 28.06.2019
(51) Int. Cl.: H01F 38/30, H01F 27/02, H01F 27/26, G01R 15/18

(54) **CURRENT TRANSFORMER**
STROMWANDLER
TRANSFORMATEUR DE COURANT

(30) Priority: 02.07.2018 CN 201810707751
(43) Date of publication of application: 12.05.2021
(73) Proprietor: FLUKE CORPORATION, Everett Washington 98203 (US)
(72) Inventor: LUO, Shounan, Shanghai 200335 (CN); LI, Fang, Shanghai 200335 (CN)
(74) Representative: HGF
(86) International application number: PCT/CN2019/093544
(87) International publication number: WO 2020/007239

(56) References cited:
- EP-A1- 2 993 678
- CN-A- 102 401 853
- CN-A- 102 496 446
- CN-U- 201 503 765
- CN-U- 204 155 745
- CN-Y- 201 336 216
- JP-A- 2009 058 428
- JP-A- H06 258 347
- JP-A- S5 396 428
- JP-A- S63 197 314
- JP-U- H02 115 176
- US-A1- 2013 063 140

## Description

### TECHNICAL FIELD

The present application relates to electronic measurement technology, and in particular relates to a detachable current transformer.

### BACKGROUND

With the wide application of various power systems in industrial production and daily life, a device capable of accurately and conveniently measuring current is needed to monitor the power systems for a safe and effective operation thereof. A traditional ring current transformer can only be used to measure AC current, and cannot measure DC current. Moreover, when measuring AC current with low frequency, a ring current transformer produces a large error. Therefore, when there are both DC current and AC current, an instrument which can accurately measure AC and DC components of current is needed.

At present, there is a current transformer having a plurality of ring-shaped ion cores, which can simultaneously measure the AC component and DC component of the current in a conducting wire passing therethrough, and has high measurement accuracy. However, when measuring using the multi-core current transformer, at least one end of the conducting wire needs to be disconnected from the circuit in order to make the conducting wire under test pass through an enclosed area of the transformer, which will cause temporary power outage of the system. In many cases, this temporary power outage will lead to great economic losses and even security risks.

Therefore, we need an instrument that can accurately measure current in a cable under test without power outage.

Document US 2013/063140 A1 discloses a magnetic sensor including two sensor units with curved cores including meshing portions at the front and base ends thereof.

Document JP H02 115176 U discloses a divided current meter comprising semiannular first and second cases having their circumferential ends joined to form an annular shape.

Document JP S53 96428 A discloses a pair of clip-type transformers to inject a current into a ground wire of a common grounding system of a distribution line.

Document JP 2009 058428 A discloses an insulation monitor including an injection transformer for injecting low frequency current between a power line and a ground.

Document JP S63 197314 A discloses a DC current transformer suitable for measuring a current of an existing DC line.

### SUMMARY

The purpose of the present application is to provide a detachable multi-core current transformer, which can measure current in a cable under test without power outage.

Disclosed in the present application is a current transformer as defined in claim 1, which includes a first transformer assembly and a second transformer assembly, wherein two ends of the first transformer assembly are provided with a first assembly end and a second assembly end, the first transformer assembly includes a first group of stacked iron core components, the first group of iron core components is provided with a first interface defined at the first assembly end and a second interface defined at the second assembly end; two ends of the second transformer assembly are provided with a third assembly end and a fourth assembly end, the second transformer assembly includes a second group of stacked iron core components, the second group of iron core components is provided with a third interface defined at the third assembly end and a fourth interface defined at the fourth assembly end. At least one of the first interface and the second interface is detachably connected with at least one of the third interface and the fourth interface, so as to detachably connect the first transformer assembly and the second transformer assembly; the first transformer assembly and the second transformer assembly are configured such that when connected with each other, the first group of iron core components and the second group of iron core components are combined to form a plurality of closed ring-shaped iron cores, and at least two closed ring-shaped iron cores of the plurality of closed ring-shaped iron cores are respectively wound with coils; an enclosed area is defined between the first transformer assembly and the second transformer assembly such that when a cable under test passes through the enclosed area, induced current related to current in the cable under test is generated in at least one coil of the coils.

In some embodiments, at least one coil is wound on the outside of the plurality of closed ring-shaped iron cores and is configured to generate induced current related to the current in the cable under test when the cable under test passes through the enclosed area.

In some embodiments, the first group of iron core components includes two iron core components, the second group of iron core components includes two iron core components, and when the first transformer assembly and the second transformer assembly are connected with each other, the two iron core components of the first group of iron core components and the two iron core components of the second group of iron core components are combined to form two closed ring-shaped iron cores, each closed ring-shaped iron core is respectively wound with a coil, and the outside of the two closed ring-shaped iron cores are further wound with two coils.

In some embodiments, the first group of iron core components includes three iron core components, the second group of iron core components includes three iron core components, and when the first transformer assembly and the second transformer assembly are connected with each other, the three iron core components of the first group of iron core components and the three iron core components of the second group of iron core components are combined to form three closed ring-shaped iron cores, each closed ring-shaped iron core is respectively wound with a coil, and the outside of the three closed ring-shaped iron cores is further wound with a coil.

In some embodiments, the first group of iron core components includes four iron core components, the second group of iron core components includes four iron core components, and when the first transformer assembly and the second transformer assembly are connected with each other, the four iron core components of the first group of iron core components and the four iron core components of the second group of iron core components are combined to form four closed ring-shaped iron cores, and each closed ring-shaped iron core is respectively wound with a coil.

In some embodiments, the first transformer assembly further includes a first housing, and the first housing is configured to confine the first group of iron core components therein; the second transformer assembly further includes a second housing, and the second housing is configured to confine the second group of iron core components therein; the first housing and the second housing are configured such that when the first transformer assembly and the second transformer assembly are connected with each other, the first housing and the second housing are combined to form a closed ring-shaped housing, so as to accommodate the plurality of closed ring-shaped iron cores therein, and the at least one coil wound on the outside of the plurality of closed ring-shaped iron cores is wound on the closed ring-shaped housing.

In some embodiments, at least one of the first interface and the second interface and at least one of the third interface and the fourth interface are provided with interdigitated structures, and the interdigitated structures are capable of being connected with each other in an interdigitated manner when the interfaces are connected with each other.

In some embodiments, each of the first interface, the second interface, the third interface and the fourth interface is provided with a guide member to guide the connection of the interface.

In some embodiments, the guide member of each interface includes a plurality of guide elements, each guide element surrounds one end of one iron core component of the first group of iron core components or the second group of iron core components, each guide element is provided with a paired protrusion part and recess part, and when one interface is connected with another interface, a paired protrusion part and recess part thereof are mated with a paired protrusion part and recess part of a guide element of the other interface.

In some embodiments, the current transformer further includes one or more fasteners for fixing the first transformer assembly and the second transformer assembly together when the interfaces are connected with each other.

In some embodiments, the first interface is detachably connected with the third interface, and the second interface is detachably connected with the fourth interface.

In some embodiments, the first transformer assembly and the second transformer assembly are in a semicircular ring shape.

In some embodiments, at least two iron core components of the first group of iron core components and at least two iron core components of the second group of iron core components are wound with coils, and when the first transformer assembly and the second transformer assembly are connected with each other, the coils respectively wound on the at least two closed ring-shaped iron cores of the plurality of closed ring-shaped iron cores are formed by the coils on at least two iron core components of the first group of iron core components connected with the coils on at least two corresponding iron core components of the second group of iron core components.

In some embodiments, the outside of the first group of iron core components is wound with at least one coil, the outside of the second group of iron core components is wound with at least one coil, and when the first transformer assembly and the second transformer assembly are connected with each other, at least one coil wound on the outside of the plurality of closed ring-shaped iron cores is formed by the at least one coil wound on the outside of the first group of iron core components connected with the at least one corresponding coil wound on the outside of the second group of iron core components.

In some embodiments, the coil wound on each iron core component of the first group of ion iron core components substantially extends over the entire length from the first assembly end to the second assembly end.

In some embodiments, the coil wound on each iron core component of the second group of ion iron core components substantially extends over the entire length from the third assembly end to the fourth assembly end.

In some embodiments, at least one iron core component of the first group of iron core components and the second group of iron core components is made of an iron-nickel alloy material.

In some embodiments, the outside of the iron core components and the coils of the first transformer assembly and the second transformer assembly is provided with a metal shielding layer for shielding an external electric field.

In some embodiments, the first transformer assembly further includes a first housing, the first housing is configured to confine the first group of iron core components therein, and the first housing is accommodated in the metal shielding layer; and the second transformer assembly further includes a second housing, the second housing is configured to confine the second group of iron core components therein, and the second housing is accommodated in the metal shielding layer.

The foregoing is a summary of the present application where simplification, generalization, and omitted details may exist. Therefore, it should be appreciated by those skilled in the art that this section is for exemplary illustration only, and not intended to limit the scope of the present application by any means. This summary section is not intended to identify key features or essential features of the claimed subject matter, and is not intended to be used as a supplementary means to identify the scope of the claimed subject matter.

### BRIEF DESCRIPTION OF THE DRAWINGS

The aforementioned and other features of the present application will be more fully and clearly understood through the specification below and the appended claims with reference to the accompanying drawings. It can be understood that these accompanying drawings illustrate only a few embodiments of the present application, and therefore should not be considered as limiting the scope of the present claims.

By using the drawings, the content of the present application will be more clearly described in detail.
FIG. 1 illustrates an overall structural schematic view of a detachable multi-core current transformer according to one embodiment of the present application.
FIG. 2 illustrates a structural schematic view of a transformer assembly in the current transformer illustrated in FIG. 1.
FIG. 3 illustrates an exploded schematic view of components of a transformer assembly in the current transformer illustrated in FIG. 1.
FIG. 4 illustrates an interface schematic view of a transformer assembly in the current transformer illustrated in FIG. 1.
FIG. 5 illustrates a structural schematic view after mounting of three closed ring-shaped iron cores in the current transformer illustrated in FIG. 1.
FIG. 6 illustrates a schematic diagram of a circuit for sensing primary current in a cable under test according to another embodiment of the present application.

### DETAILED DESCRIPTION

The following detailed description is made with reference to the accompanying drawings constituting a part of the description. Unless otherwise specified in the context, similar reference numerals usually represent similar components in the accompanying drawings.

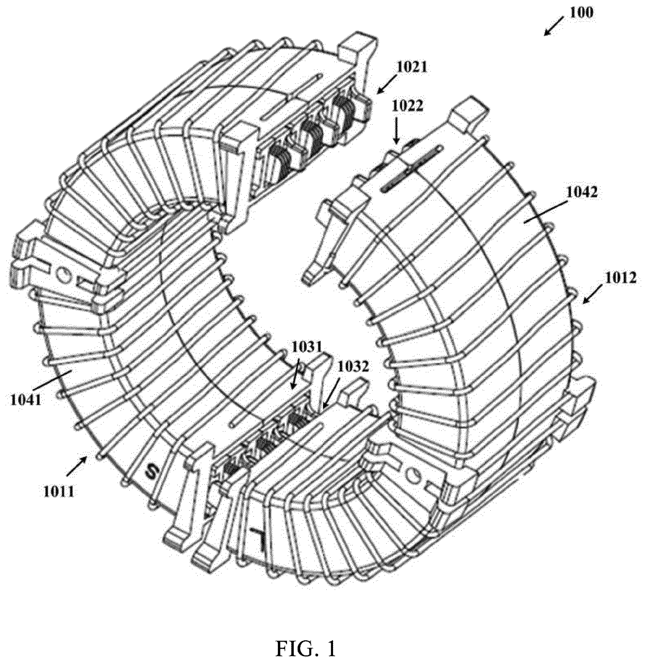

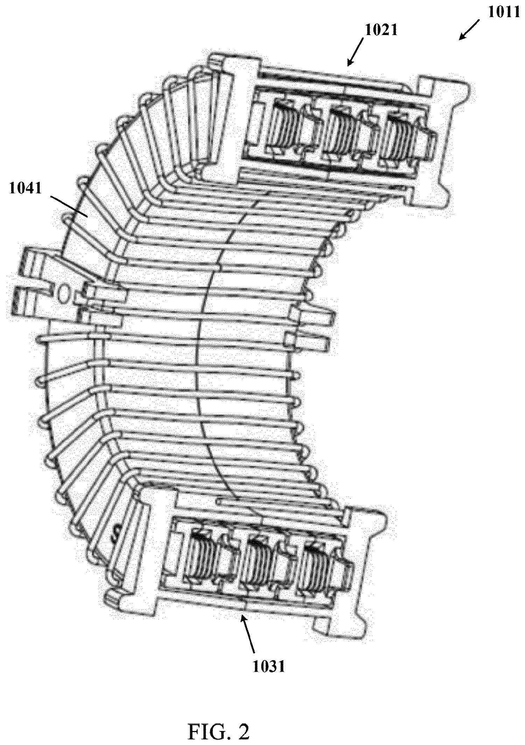

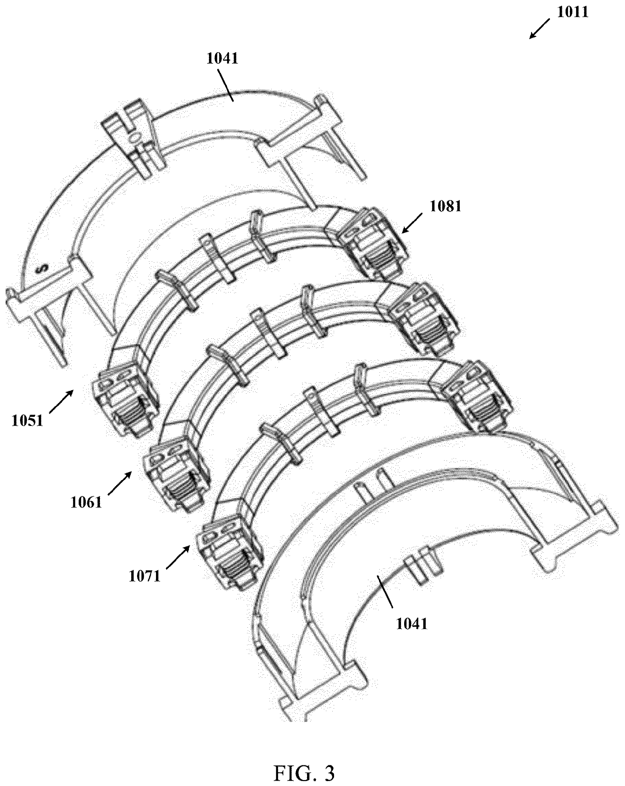

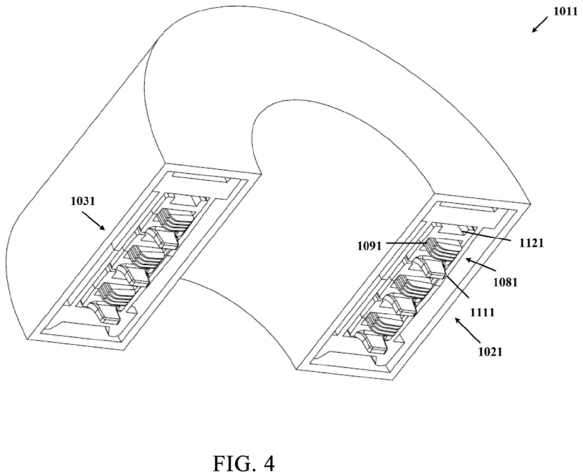

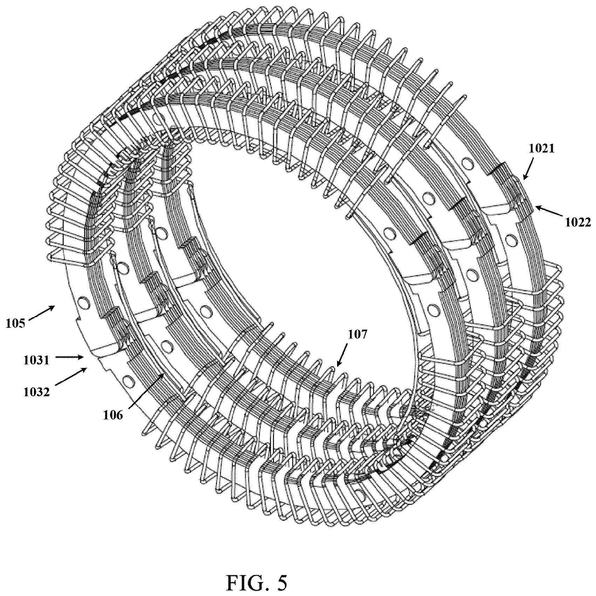

FIG. 1 to FIG. 5 illustrate a detachable multi-core current transformer 100 according to one embodiment of the present application. FIG. 1 illustrates an overall structural schematic view of the detachable multi-core current transformer; FIG. 2 and FIG. 3 illustrate a structural schematic view of a transformer assembly (for example, a first transformer assembly) in the detachable multi-core current transformer; FIG. 4 illustrates an interface schematic view of a transformer assembly (for example, first transformer assembly) in the detachable multi-core current transformer; FIG. 5 illustrates a structural schematic view after connection of three closed ring-shaped iron cores in the detachable multi-core current transformer. It should be understood that the current transformer having three iron cores illustrated in the drawings of the present application is only exemplary, and a detachable multi-core current transformer having two or four iron cores or other number of iron cores may also be used to simultaneously measure AC and DC components of current in a cable under test.

As illustrated in FIG. 1, the current transformer 100 includes a first transformer assembly 1011 and a second transformer assembly 1012. The first transformer assembly 1011 is substantially in a semi-ring shape, two ends of which are respectively a first assembly end and a second assembly end. The second transformer assembly 1012 is substantially in a semi-ring shape, two ends of which are respectively a third assembly end and a fourth assembly end. After connected, the two transformer assemblies 1011 and 1012 are substantially in a circular ring shape. In some embodiments, the first transformer assembly 1011 may also be in a semi-ring shape with an extended radian of no more than 180 degrees, such as an arc of about 120 degrees or an arc of other radians. Correspondingly, the second transformer assembly 1012 may be in a semi-ring shape with an extended radian of more than 180 degrees, such as an arc of about 240 degrees or an arc of other radians. The two transformer assemblies 1011 and 1012 may also be in other suitable shapes as long as when the two transformer assemblies are connected with each other, an enclosed area can be defined therebetween for a cable under test to pass therethrough.

The first transformer assembly 1011 includes a first housing 1041, the second transformer assembly 1012 includes a second housing 1042, and the first housing and second housing are respectively wound with coils. The first assembly end, the second assembly end, the third assembly end and the fourth assembly end are respectively provided with a first interface 1021, a second interface 1031, a third interface 1022, and a fourth interface 1032. The first interface 1021 may be detachably connected with the third interface 1022, and the second interface 1031 may be detachably connected with the fourth interface 1032, such that the two transformer assemblies can be conveniently mounted and dismounted, and the current transformer 100 can be switched between an open state and a closed state. In some embodiments, a coil may be wound only on the first housing or only on the second housing.

In some embodiments, only the first interface 1021 and the third interface 1022 can be disconnected from each other, and the second interface 1031 and the fourth interface 1032 are always connected with each other, such that when the current transformer 100 is in an open state, the two transformer assemblies can be partially separated. In the actual measurement, when the first interface 1021 and the third interface 1022 are disconnected from each other, a gap therebetween only needs to be larger than the diameter of the cable under test such that the cable under test is allowed to pass therethrough. In some alternative embodiments, only the second interface 1031 and the fourth interface 1032 can be disconnected from each other.

As illustrated in FIG. 2 to FIG. 3, the first transformer assembly 1011 includes a first group of three iron core components 1051, 1061 and 1071, which are enclosed in the first housing 1041. In the present embodiment, the three iron core components are substantially in a semi-ring shape, have substantially the same size, and are vertically stacked on top of one another, such that two ends of all iron core components are aligned with one another, and the adjacent iron core components are electrically isolated from each other. The iron core components are made of a magnetic material such as iron, nickel or iron-nickel alloy, and the magnetic material is preferably an iron-nickel alloy material, such as permalloy. Alternatively, the outside of the first housing is further provided with a metal shielding layer (not shown), which accommodates the first housing 1041, the first group of three iron core components, and coils on each iron core component and the first housing, so as to protect the iron cores from being affected by an external electric field. In some alternative embodiments, the metal shielding layer is included in the first housing 1041.

Each iron core component 1051, 1061, or 1071 is wound with a coil (not shown), and optionally, the coil wound on each iron core component substantially extends over the entire length from the first assembly end to the second assembly end. The two ends of each iron core component are respectively provided with interdigitated structures at the first interface 1021 and the second interface 1031 for connecting with the interdigitated structures of the third interface 1022 and the fourth interface 1032 in an interdigitated manner. The interdigitated structures may have high mating accuracy. For example, the unilateral gap between digits may be as small as 0.05mm.

The first interface 1021 and the second interface 1031 may be respectively provided with a guide member for guiding the connection between the interfaces. For example, as illustrated FIG. 4, the guide member at the first interface 1021 includes three guide elements, and each guide element surrounds one end of one iron core component of the first group of three iron core components to guide the connection between the first interface 1021 and the third interface 1022. Taking a guide element 1081 surrounding one end of an iron core component 1051 (not shown in FIG. 4) at the first interface 1021 as an example, the guide element 1081 includes a protrusion part 1111 and a recess part 1121, which are respectively located on the two sides of the interdigitated structure 1091 at one end of the iron core component 1051. When the first interface 1021 is connected with, for example, the third interface 1022 (not shown in FIG. 4), the protrusion part 1111 is mated with the recess part of the guide element of the third interface 1022, and the recess part 1121 is mated with the protrusion part of the guide element of the third interface 1022. The other two guide elements at the first interface 1021 and the three guide elements at the second interface 1031 have the same structure as the guide element 1081, which will not be repeated here. According to the needs, one interface may include other numbers of guide elements. For example, the first interface 1021 and the second interface 1031 may respectively include only one guide element. At the same time, the guide member may also have other suitable structures, such as a shaft-hole mating structure. The guide member at the interface may be mounted on the first housing, the shielding layer or other components of the first transformer assembly.

The second transformer assembly 1012 includes components such as a second group of three iron core components (not shown in FIG. 2-FIG. 3) enclosed in the second housing 1042. The shape, structure and the like of the second transformer assembly 1012 and the components thereof are the same as those of the first transformer assembly 1011 or are mated with those of the first transformer assembly 1011, which will not be repeated here. Each iron core component of the second group of three iron core components corresponds to one iron core component of the first group of three iron core components.

When the two interfaces of the first transformer assembly 1011 and the two interfaces of the second transformer assembly 1012 are respectively connected with each other, the interdigitated structures at the interfaces may be interdigitated with each other to form three stacked closed ring-shaped iron cores 105, 106 and 107 (see FIG. 5). The closed ring-shaped iron cores may substantially be in a circular ring shape or any other suitable closed ring shape. The first housing 1041 is connected with the second housing 1042 to form a closed ring-shaped housing to accommodate the three closed ring-shaped iron cores therein. The three guide elements at the first interface 1021 are respectively mated with the three guide elements at the second interface 1022, and the three guide elements at the second interface 1031 are respectively mated with the three guide elements at the fourth interface 1032, such that the protrusion part in each guide element is inserted into the recess part in the corresponding guide element to guide the interfaces to be aligned with each other during connection and prevent offset. One end of the coil on each iron core component is connected with one end of the coil on the corresponding iron core component on the other transformer assembly, such that each stacked closed ring-shaped iron core is wound with a complete coil, which facilitates current sensing. Similarly, after mounting, one end of the coil wound on the first housing 1041 and one end of the coil wound on the second housing 1042 are also connected with each other at the interfaces to form a complete coil wound on the complete housing.

In some embodiments, for at least one closed ring-shaped iron core, the coil is wound only on one iron core component of the two corresponding iron core components forming the closed ring-shaped iron core, that is, the coil is wound only on one half of a certain closed ring-shaped iron core, and the coil is not wound on the other half. The current transformer of this design may also realize the measurement of the DC component and the AC components of the current.

In some embodiments, the first housing and the second housing may be omitted, and the coils wound on the first housing and the second housing may be directly wound on the outside of the first group of the three stacked iron core components and the second group of the three stacked iron core components, respectively.

In some embodiments, the current transformer may further include one or more fasteners for fixing the first transformer assembly and the second transformer assembly together when the interfaces are connected with each other. The fastener may be a bolt and a nut or any other suitable element for fastening connection, which is not limited in the present application.

In order to measure the current in the cable under test, a user may firstly disconnect the first interface from the third interface and/or the second interface from the fourth interface, such that the current transformer 100 is in an open state, and the first transformer assembly 1011 and the second transformer assembly 1012 are at least partially separated, so that the cable under test can be placed in an opening between the disconnected interfaces and thus located between the two transformer assemblies. The operator may then reconnect the disconnected interfaces such that the two transformer assemblies can be remounted to form a closed current transformer 100, and the cable under test can pass through and remains in an enclosed area defined between the two transformer assemblies. When the current flows through the cable under test, induced current related to the current under test is generated in the coil wound on the closed ring-shaped iron core. In particular, the current in the cable under test can be conveniently and accurately measured by measuring the induced current in the coil on the closed ring-shaped housing.

In the present embodiment, provided is a multi-core current transformer which can be disassembled into two separate transformer assemblies. The cable under test can enter and pass through the enclosed area in the current transformer without powering off the equipment under test, such that the DC and AC components of the current in the cable under test can be conveniently measured. The measuring equipment is especially suitable for the measurement of equipment which is not convenient to power off and start, such as solar power generation testing, medical instrument testing, electric vehicle testing, power analysis, and power quality testing.

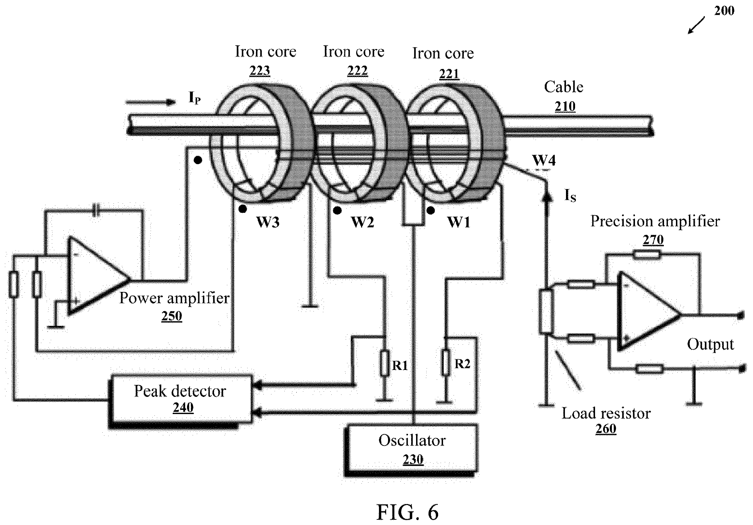

FIG. 6 illustrates a circuit 200 for measuring current by using the detachable multi-core current transformer illustrated in FIG. 1 to FIG. 5. The circuit 200 includes a detachable multi-core current transformer 220 in a connected state, which includes three closed ring-shaped iron cores 221, 222 and 223 stacked sequentially. The specific structure of the current transformer 220 has been described in detail with reference to FIG. 1 to FIG. 5 above. For the purpose of clarity, only three closed ring-shaped iron cores in the current transformer in the connected state and coils wound on each iron core are illustrated in FIG. 6, while other components in the current transformer are omitted. A coil W1 is wound on the iron core 221, a coil W2 is wound on the iron core 222, a coil W3 is wound on the iron core 223, a coil W4 is wound on a housing (not shown) enclosing the three iron cores, and the dotted terminals of the coils are marked with black dots in the figures. A cable under test 210 passes through an internal area in the three closed ring-shaped iron cores, and primary current IP flows through the cable under test 210. It should be understood that a current transformer having two iron cores or four iron cores or other number of iron cores may also be used to implement the circuit illustrated in FIG. 6.

The circuit 200 further includes an oscillator 230, which is coupled to the dotted terminal of the coil W1 and the non-dotted terminal of the coil W2 and used to drive the iron core 221 and the iron core 222. The non-dotted terminal of the coil W1 and the dotted terminal of the coil W2 are respectively coupled to a first input terminal and a second input terminal of a peak detector 240, and the first input terminal and the second input terminal of the peak detector 240 are grounded through a resistor R1 and a resistor R2 respectively. An output terminal of the peak detector 240 is coupled to a first input terminal of a power amplifier 250, the first input terminal of the power amplifier 250 is also coupled to the dotted terminal of the coil W3, and a second input terminal of the power amplifier 250 and the non-dotted terminal of the coil W3 are grounded respectively. An output terminal of the power amplifier 250 is coupled to the dotted terminal of the coil W4.

In the circuit 200, the primary current IP flowing through the cable under test 210 generates a flux in the iron core, which is offset by secondary current IS in the coil W4. All remaining flux will be sensed by the three closed ring-shaped iron cores 221, 222 and 223 wound with coils.

The iron core 221 and the iron core 222 are used to sense the DC part of the remaining flux, and the iron core 223 is used to sense the AC part of the remaining flux. The oscillator 230 drives, in an opposite direction, the two iron cores (221, 222) for sensing the DC part of the induced current to be in a saturated state. If the remaining DC flux is 0, the peak values of the generated current in two directions are equal; if the remaining DC flux is not 0, the difference between the peak values is directly proportional to the remaining DC flux. The peak detector 240 is a dual-peak detector for measuring the DC component of the primary current IP by comparing the peak values of the currents in the two directions. The iron core 223 is used to induce the AC component of the primary current IP and to generate induced current in the coil W3. After adding the AC component induced by the iron core 223 to the output of the peak detector 240, a control loop is formed to generate the secondary current IS to make the flux zero. The power amplifier 250 supplies the secondary current IS to the coil W4. The secondary current IS is mirror current which is proportional to the primary current IP. The measurement of the current IP under test can be realized by measuring the secondary current IS.

In some embodiments, the non-dotted terminal of the coil W4 is connected to a load resistor 260 to convert a current signal in W4 into voltage. The two ends of the load resistor 260 are also coupled to two input terminals of a precision amplifier 270. The precision amplifier 270 is a very stable differential amplifier which generates output voltage with high accuracy, the output voltage is proportional to the secondary current IS, and thus it can be used to represent the primary current IP in the cable under test.

The number of turns of the coils W1, W2, W3 and W4 illustrated in FIG. 6 is only exemplary. In practice, an appropriate number of turns may be selected according to the actual needs to implement the present invention.

FIG. 6 illustrates a circuit for sensing current based on peak detection. It should be understood that the detachable multi-core current transformer disclosed in the present application may also be used in other suitable current measurement circuits, for example, a circuit based on self-excited oscillation detection, a circuit based on second harmonic detection, etc.

In practice, the current transformer in FIG. 1 to FIG. 5 may also be implemented as having other number of iron cores. In some embodiments, the detachable multi-core current transformer may be provided with two iron cores, and the structure thereof is substantially the same as that of the detachable three-core current transformer described with reference to FIG. 1 to FIG. 5, except that each of the first group of iron core components and the second group of iron core components includes two iron core components. In this way, when the first transformer assembly and the second transformer assembly are connected with each other, two closed ring-shaped iron cores can be formed. Each closed ring-shaped iron core is wound with a coil, which is equivalent to the coils W1 and W2 in FIG. 6. The outside of the two closed ring-shaped iron cores is further wound with two coils, which are equivalent to the coils W3 and W4 in FIG. 6. When the cable under test passes through the enclosed area defined between the two transformer assemblies, the current in the cable under test can be measured by measuring the induced current in the coil equivalent to W4.

In some embodiments, the detachable multi-core current transformer may be provided with four iron cores, and the structure thereof is substantially the same as that of the detachable three-core current transformer described with reference to FIG. 1 to FIG. 5, except that each of the first group of iron core components and the second group of iron core components includes four iron core components. In this way, when the first transformer assembly and the second transformer assembly are connected with each other, four closed ring-shaped iron cores can be formed. Each closed ring-shaped iron core is wound with a coil, which is equivalent to the coils W1, W2, W3 and W4 in FIG. 6. When the cable under test passes through the enclosed area defined between the two transformer assemblies, the current in the cable under test can be measured by measuring the induced current in the coil equivalent to W4.

It should be noted that although several modules or sub-modules of the current transformer and the current measurement circuit using the same have been mentioned in the above detailed description, such division is exemplary and not mandatory. Practically, according to the embodiments of the present application, the features and functions of two or more modules described above may be embodied in one module. Conversely, the feature and function of one module described above may be divided and embodied in multiple modules.

Other variations to the disclosed embodiments can be understood and effected by those of ordinary skill in the art from a study of the specification, the disclosed contents, the accompanying drawings, and the appended claims. In the claims, the word "comprise" does not exclude other elements or steps, and the word "a" or "an" does not exclude plurality. In practical application of the present application, one component may perform functions of multiple technical features referred to in the claims. Any reference signs in the claims should not be construed as limiting the scope of the claims.

## Claims

1. A current transformer comprising:
a first transformer assembly (1011), two ends of the first transformer assembly being provided with a first assembly end and a second assembly end, the first transformer assembly comprising a first group of stacked iron core components, the first group of iron core components being provided with a first interface (1021) defined at the first assembly end and a second interface (1031) defined at the second assembly end;
a second transformer assembly (1012), two ends of the second transformer assembly being provided with a third assembly end and a fourth assembly end, the second transformer assembly comprising a second group of stacked iron core components, the second group of iron core components being provided with a third interface (1022) defined at the third assembly end and a fourth interface (1032) defined at the fourth assembly end; and
a plurality of coils, the plurality of coils comprising a first coil (W1), second coil (W2), third coil (W3), and fourth coil (W4),
wherein at least one of the first interface (1021) and the second interface (1031) is detachably connected with at least one of the third interface (1022) and the fourth interface (1032), so as to detachably connect the first transformer assembly (1011) and the second transformer assembly (1012);
the first transformer assembly and the second transformer assembly are configured such that when connected with each other, the first group of iron core components and the second group of iron core components are combined to form a plurality of closed ring-shaped iron cores, and at least two closed ring-shaped iron cores (221, 222) of the plurality of closed ring-shaped iron cores are respectively wound with one of the first coil (W1) and the second coil (W2);
an enclosed area is defined between the first transformer assembly and the second transformer assembly such that when a cable under test (210) passes through the enclosed area, an induced current related to current in the cable under test (210) is generated in at least one coil of the plurality of coils;
the fourth coil (W4) is configured to generate induced current related to the current in the cable under test when the cable under test (210) passes through the enclosed area, **characterized in that**
the first and second coils (W1, W2) are arranged to determine a DC component of the induced current, and the third coil (W3) is arranged to detemine an AC component of the induced current.

2. The current transformer according to claim 1, wherein the fourth coil (W4) is wound on the outside of the plurality of closed ring-shaped iron cores (221, 222, 223).

3. The current transformer according to claim 2, wherein the first group of iron core components comprises two iron core components, the second group of iron core components comprises two iron core components, and when the first transformer assembly and the second transformer assembly are connected with each other, the two iron core components of the first group of iron core components and the two iron core components of the second group of iron core components are combined to form two closed ring-shaped iron cores (221, 222), each closed ring-shaped iron core is respectively wound with one of the first coil (W1) and the second coil (W2), and the outside of the two closed ring-shaped iron cores are further wound with the third coil (W3) and the fourth coil (W4).

4. The current transformer according to claim 2, wherein the first group of iron core components comprises three iron core components, the second group of iron core components comprises three iron core components, and when the first transformer assembly and the second transformer assembly are connected with each other, the three iron core components of the first group of iron core components and the three iron core components of the second group of iron core components are combined to form three closed ring-shaped iron cores (221, 222, 223), each closed ring-shaped iron core is respectively wound with one of the first coil (W1), the second coil (W2), and the third coil (W3), and the outside of the three closed ring-shaped iron cores is further wound with the fourth coil (W4).

5. The current transformer according to claim 1, wherein the first group of iron core components comprises four iron core components, the second group of iron core components comprises four iron core components, and when the first transformer assembly and the second transformer assembly are connected with each other, the four iron core components of the first group of iron core components and the four iron core components of the second group of iron core components are combined to form four closed ring-shaped iron cores (221, 222, 223), and each closed ring-shaped iron core is respectively wound with one of the first coil (W1), the second coil (W2), the third coil (W3), and the fourth coil (W4).

6. The current transformer according to any one of claims 2-4, wherein
the first transformer assembly further comprises a first housing, and the first housing is configured to confine the first group of iron core components therein;
the second transformer assembly further comprises a second housing, and the second housing is configured to confine the second group of iron core components therein; and
the first housing and the second housing are configured such that when the first transformer assembly and the second transformer assembly are connected with each other, the first housing and the second housing are combined to form a closed ring-shaped housing so as to accommodate the plurality of closed ring-shaped iron cores therein, and at least the fourth coil (W4) wound on the outside of the plurality of closed ring-shaped iron cores is wound on the closed ring-shaped housing.

7. The current transformer according to any one of claims 1-6, wherein at least one of the first interface and the second interface and at least one of the third interface and the fourth interface are provided with interdigitated structures, and the interdigitated structures are capable of being connected with each other in an interdigitated manner when the interfaces are connected with each other, and/or
wherein each of the first interface, the second interface, the third interface and the fourth interface is provided with a guide member to guide the connection of the interface.

8. The current transformer according to claim 7, wherein the guide member of each interface comprises a plurality of guide elements, each guide element surrounds one end of one iron core component of the first group of iron core components or the second group of iron core components, each guide element is provided with a paired protrusion part and recess part, and when one interface is connected with another interface, a paired protrusion part and recess part thereof are mated with a paired protrusion part and recess part of a guide element of the other interface.

9. The current transformer according to any one of claims 1-8, further comprising one or more fasteners for fixing the first transformer assembly and the second transformer assembly together when the interfaces are connected with each other.

10. The current transformer according to any one of claims 1-9, wherein the first interface is detachably connected with the third interface, and the second interface is detachably connected with the fourth interface, and/or
wherein the first transformer assembly and the second transformer assembly are in a semicircular ring shape.

11. The current transformer according to any one of claims 1-10, wherein at least two iron core components of the first group of iron core components are wound with a first part of the first coil and a first part of the second coil, and at least two iron core components of the second group of iron core components are wound with a second part of the first coil and a second part of the second coil, and when the first transformer assembly and the second transformer assembly are connected with each other, the first and second coils respectively wound on the at least two closed ring-shaped iron cores of the plurality of closed ring-shaped iron cores are formed by the first part of the first coil and the first part of the second coil on at least two iron core components of the first group of iron core components connected with the second part of the first coil and the second part of the second coil on at least two corresponding iron core components of the second group of iron core components.

12. The current transformer according to any one of claims 2-11, wherein the outside of the first group of iron core components is wound with a first part of the fourth coil, the outside of the second group of iron core components is wound with a second part of the fourth coil, and when the first transformer assembly and the second transformer assembly are connected with each other, the fourth coil wound on the outside of the plurality of closed ring-shaped iron cores is formed by the first part of the fourth coil wound on the outside of the first group of iron core components connected with the second part of the fourth coil wound on the outside of the second group of iron core components.

13. The current transformer according to any one of claims 1-12, wherein each of the first and second coil wound on each iron core component of the first group of iron core components respectively extends over the entire length from the first assembly end to the second assembly end, and/or
wherein each of the first and second coil wound on each iron core component of the second group of iron core components respectively extends over the entire length from the third assembly end to the fourth assembly end.

14. The current transformer according to any one of claims 1-13, wherein at least one iron core component of the first group of iron core components and the second group of iron core components is made of an iron-nickel alloy material, and/or
wherein the outside of the iron core components and the coils of the first transformer assembly and the second transformer assembly is provided with a metal shielding layer for shielding an external electric field.

15. The current transformer according to claim 14, wherein
the first transformer assembly further comprises a first housing, the first housing is configured to confine the first group of iron core components therein, and the first housing is accommodated in the metal shielding layer; and
the second transformer assembly further comprises a second housing, the second housing is configured to confine the second group of iron core components therein, and the second housing is accommodated in the metal shielding layer.

## Patentansprüche

1. Stromwandler, umfassend:
eine erste Wandlerbaugruppe (1011), wobei zwei Enden der ersten Wandlerbaugruppe mit einem ersten Baugruppenende und einem zweiten Baugruppenende bereitgestellt sind, wobei die erste Wandlerbaugruppe eine erste Gruppe von gestapelten Eisenkernkomponenten umfasst, wobei die erste Gruppe von Eisenkernkomponenten mit einer ersten Schnittstelle (1021), die an dem ersten Baugruppenende definiert ist, und einer zweiten Schnittstelle (1031), die an dem zweiten Baugruppenende definiert ist, bereitgestellt ist;
eine zweite Wandlerbaugruppe (1012), wobei zwei Enden der zweiten Wandlerbaugruppe mit einem dritten Baugruppenende und einem vierten Baugruppenende bereitgestellt sind, wobei die zweite Wandlerbaugruppe eine zweite Gruppe von gestapelten Eisenkernkomponenten umfasst, wobei die zweite Gruppe von Eisenkernkomponenten mit einer dritten Schnittstelle (1022), die an dem dritten Baugruppenende definiert ist, und einer vierten Schnittstelle (1032), die an dem vierten Baugruppenende definiert ist, bereitgestellt ist; und
eine Vielzahl von Spulen, wobei die Vielzahl von Spulen eine erste Spule (W1), eine zweite Spule (W2), eine dritte Spule (W3) und eine vierte Spule (W4) umfasst,
wobei zumindest eine von der ersten Schnittstelle (1021) und der zweiten Schnittstelle (1031) lösbar mit zumindest einer von der dritten Schnittstelle (1022) und der vierten Schnittstelle (1032) verbunden ist, um die erste Wandlerbaugruppe (1011) und die zweite Wandlerbaugruppe (1012) lösbar zu verbinden;
wobei die erste Wandlerbaugruppe und die zweite Wandlerbaugruppe konfiguriert sind, sodass, wenn sie miteinander verbunden sind, die erste Gruppe von Eisenkernkomponenten und die zweite Gruppe von Eisenkernkomponenten kombiniert sind, um eine Vielzahl von geschlossenen ringförmigen Eisenkernen zu bilden, und zumindest zwei geschlossene ringförmige Eisenkerne (221, 222) aus der Vielzahl von geschlossenen ringförmigen Eisenkernen jeweils mit einer von der ersten Spule (W1) und der zweiten Spule (W2) gewickelt sind;
wobei ein umschlossener Bereich zwischen der ersten Wandlerbaugruppe und der zweiten Wandlerbaugruppe definiert ist, sodass, wenn ein zu prüfendes Kabel (210) durch den umschlossenen Bereich verläuft, ein induzierter Strom in Bezug auf Strom in dem zu prüfenden Kabel (210) in zumindest einer Spule aus der Vielzahl von Spulen erzeugt wird;
wobei die vierte Spule (W4) konfiguriert ist, um induzierten Strom in Bezug auf den Strom in dem zu prüfenden Kabel zu erzeugen, wenn das zu prüfende Kabel (210) durch den umschlossenen Bereich verläuft,
**dadurch gekennzeichnet, dass**
die erste und die zweite Spule (W1, W2) angeordnet sind, um eine Gleichstromkomponente des induzierten Stroms zu bestimmen, und die dritte Spule (W3) angeordnet ist, um eine Wechselstromkomponente des induzierten Stroms zu bestimmen.

2. Stromwandler nach Anspruch 1, wobei die vierte Spule (W4) auf die Außenseite der Vielzahl von geschlossenen ringförmigen Eisenkernen (221, 222, 223) gewickelt ist.

3. Stromwandler nach Anspruch 2, wobei die erste Gruppe von Eisenkernkomponenten zwei Eisenkernkomponenten umfasst, die zweite Gruppe von Eisenkernkomponenten zwei Eisenkernkomponenten umfasst, und wenn die erste Wandlerbaugruppe und die zweite Wandlerbaugruppe miteinander verbunden sind, die zwei Eisenkernkomponenten der ersten Gruppe von Eisenkernkomponenten und die zwei Eisenkernkomponenten der zweiten Gruppe von Eisenkernkomponenten kombiniert sind, um zwei geschlossene ringförmige Eisenkerne (221, 222) zu bilden, wobei jeder geschlossene ringförmige Eisenkern jeweils mit einer von der ersten Spule (W1) und der zweiten Spule (W2) gewickelt ist, und die Außenseite der zwei geschlossenen ringförmigen Eisenkerne ferner mit der dritten Spule (W3) und der vierten Spule (W4) gewickelt ist.

4. Stromwandler nach Anspruch 2, wobei die erste Gruppe von Eisenkernkomponenten drei Eisenkernkomponenten umfasst, die zweite Gruppe von Eisenkernkomponenten drei Eisenkernkomponenten umfasst, und wenn die erste Wandlerbaugruppe und die zweite Wandlerbaugruppe miteinander verbunden sind, die drei Eisenkernkomponenten der ersten Gruppe von Eisenkernkomponenten und die drei Eisenkernkomponenten der zweiten Gruppe von Eisenkernkomponenten kombiniert sind, um drei geschlossene ringförmige Eisenkerne (221, 222, 223) zu bilden, wobei jeder geschlossene ringförmige Eisenkern jeweils mit einer von der ersten Spule (W1), der zweiten Spule (W2) und der dritten Spule (W3) gewickelt ist, und die Außenseite der drei geschlossenen ringförmigen Eisenkerne ferner mit der vierten Spule (W4) gewickelt ist.

5. Stromwandler nach Anspruch 1, wobei die erste Gruppe von Eisenkernkomponenten vier Eisenkernkomponenten umfasst, die zweite Gruppe von Eisenkernkomponenten vier Eisenkernkomponenten umfasst, und wenn die erste Wandlerbaugruppe und die zweite Wandlerbaugruppe miteinander verbunden sind, die vier Eisenkernkomponenten der ersten Gruppe von Eisenkernkomponenten und die vier Eisenkernkomponenten der zweiten Gruppe von Eisenkernkomponenten kombiniert sind, um vier geschlossene ringförmige Eisenkerne (221, 222, 223) zu bilden, und jeder geschlossene ringförmige Eisenkern jeweils mit einer von der ersten Spule (W1), der zweiten Spule (W2), der dritten Spule (W3) und der vierten Spule (W4) gewickelt ist.

6. Stromwandler nach einem der Ansprüche 2-4, wobei
die erste Wandlerbaugruppe ferner ein erstes Gehäuse umfasst und das erste Gehäuse konfiguriert ist, um die erste Gruppe von Eisenkernkomponenten darin einzuschließen;
die zweite Wandlerbaugruppe ferner ein zweites Gehäuse umfasst und das zweite Gehäuse konfiguriert ist, um die zweite Gruppe von Eisenkernkomponenten darin einzuschließen; und
das erste Gehäuse und das zweite Gehäuse konfiguriert sind, sodass, wenn die erste Wandlerbaugruppe und die zweite Wandlerbaugruppe miteinander verbunden sind, das erste Gehäuse und das zweite Gehäuse kombiniert sind, um ein geschlossenes ringförmiges Gehäuse zu bilden, um die Vielzahl von geschlossenen ringförmigen Eisenkernen darin unterzubringen, und zumindest die vierte Spule (W4), die auf die Außenseite der Vielzahl von geschlossenen ringförmigen Eisenkernen gewickelt ist, auf das geschlossene ringförmige Gehäuse gewickelt ist.

7. Stromwandler nach einem der Ansprüche 1-6, wobei zumindest eine von der ersten Schnittstelle und der zweiten Schnittstelle und zumindest eine von der dritten Schnittstelle und der vierten Schnittstelle mit interdigitierten Strukturen bereitgestellt sind und die interdigitierten Strukturen in der Lage sind, auf eine interdigitierte Weise miteinander verbunden zu sein, wenn die Schnittstellen miteinander verbunden sind, und/oder
wobei jede von der ersten Schnittstelle, der zweiten Schnittstelle, der dritten Schnittstelle und der vierten Schnittstelle mit einem Führungselement bereitgestellt ist, um die Verbindung der Schnittstelle zu führen.

8. Stromwandler nach Anspruch 7, wobei das Führungselement jeder Schnittstelle eine Vielzahl von Führungselementen umfasst, wobei jedes Führungselement ein Ende einer Eisenkernkomponente der ersten Gruppe von Eisenkernkomponenten oder der zweiten Gruppe von Eisenkernkomponenten umgibt, jedes Führungselement mit einem gepaarten Vorsprungsteil und einem gepaarten Vertiefungsteil bereitgestellt ist, und wenn eine Schnittstelle mit einer anderen Schnittstelle verbunden wird, ein gepaarter Vorsprungsteil und Vertiefungsteil davon mit einem gepaarten Vorsprungsteil und Vertiefungsteil eines Führungselements der anderen Schnittstelle zusammengefügt werden.

9. Stromwandler nach einem der Ansprüche 1-8, ferner umfassend eine oder mehrere Befestigungen zum Fixieren der ersten Wandlerbaugruppe und der zweiten Wandlerbaugruppe aneinander, wenn die Schnittstellen miteinander verbunden sind.

10. Stromwandler nach einem der Ansprüche 1-9, wobei die erste Schnittstelle lösbar mit der dritten Schnittstelle verbunden ist und die zweite Schnittstelle lösbar mit der vierten Schnittstelle verbunden ist, und/oder
wobei die erste Wandlerbaugruppe und die zweite Wandlerbaugruppe in einer halbkreisförmigen Ringform sind.

11. Stromwandler nach einem der Ansprüche 1-10, wobei zumindest zwei Eisenkernkomponenten der ersten Gruppe von Eisenkernkomponenten mit einem ersten Teil der ersten Spule und einem ersten Teil der zweiten Spule gewickelt sind und zumindest zwei Eisenkernkomponenten der zweiten Gruppe von Eisenkernkomponenten mit einem zweiten Teil der ersten Spule und einem zweiten Teil der zweiten Spule gewickelt sind, und wenn die erste Wandlerbaugruppe und die zweite Wandlerbaugruppe miteinander verbunden sind, die erste und die zweite Spule, die jeweils auf die zumindest zwei geschlossenen ringförmigen Eisenkerne aus der Vielzahl von geschlossenen ringförmigen Eisenkernen gewickelt sind, dadurch gebildet sind, dass der erste Teil der ersten Spule und der erste Teil der zweiten Spule auf zumindest zwei Eisenkernkomponenten der ersten Gruppe von Eisenkernkomponenten mit dem zweiten Teil der ersten Spule und dem zweiten Teil der zweiten Spule auf zumindest zwei entsprechenden Eisenkernkomponenten der zweiten Gruppe von Eisenkernkomponenten verbunden sind.

12. Stromwandler nach einem der Ansprüche 2-11, wobei die Außenseite der ersten Gruppe von Eisenkernkomponenten mit einem ersten Teil der vierten Spule gewickelt ist, die Außenseite der zweiten Gruppe von Eisenkernkomponenten mit einem zweiten Teil der vierten Spule gewickelt ist, und wenn die erste Wandlerbaugruppe und die zweite Wandlerbaugruppe miteinander verbunden sind, die vierte Spule, die auf die Außenseite der Vielzahl von geschlossenen ringförmigen Eisenkernen gewickelt ist, dadurch gebildet ist, dass der erste Teil der vierten Spule, der auf die Außenseite der ersten Gruppe von Eisenkernkomponenten gewickelt ist, mit dem zweiten Teil der vierten Spule, der auf die Außenseite der zweiten Gruppe von Eisenkernkomponenten gewickelt ist, verbunden ist.

13. Stromwandler nach einem der Ansprüche 1-12, wobei sich jede von der ersten und der zweiten Spule, die auf jede Eisenkernkomponente der ersten Gruppe von Eisenkernkomponenten gewickelt ist, jeweils über die gesamte Länge von dem ersten Baugruppenende zu dem zweiten Baugruppenende erstreckt, und/oder
wobei sich jede von der ersten und der zweiten Spule, die auf jede Eisenkernkomponente der zweiten Gruppe von Eisenkernkomponenten gewickelt ist, jeweils über die gesamte Länge von dem dritten Baugruppenende zu dem vierten Baugruppenende erstreckt.

14. Stromwandler nach einem der Ansprüche 1-13, wobei zumindest eine Eisenkernkomponente der ersten Gruppe von Eisenkernkomponenten und der zweiten Gruppe von Eisenkernkomponenten aus einem Eisen-Nickel-Legierungsmaterial hergestellt ist, und/oder
wobei die Außenseite der Eisenkernkomponenten und der Spulen der ersten Wandlerbaugruppe und der zweiten Wandlerbaugruppe mit einer metallischen Abschirmschicht zum Abschirmen eines externen elektrischen Feldes bereitgestellt ist.

15. Stromwandler nach Anspruch 14, wobei
die erste Wandlerbaugruppe ferner ein erstes Gehäuse umfasst, das erste Gehäuse konfiguriert ist, um die erste Gruppe von Eisenkernkomponenten darin einzuschließen, und das erste Gehäuse in der metallischen Abschirmschicht untergebracht ist; und
die zweite Wandlerbaugruppe ferner ein zweites Gehäuse umfasst, das zweite Gehäuse konfiguriert ist, um die zweite Gruppe von Eisenkernkomponenten darin einzuschließen, und das zweite Gehäuse in der metallischen Abschirmschicht untergebracht ist.

## Revendications

1. Transformateur de courant comprenant :
un premier ensemble de transformateur (1011), deux extrémités du premier ensemble de transformateur étant dotées d'une première extrémité d'ensemble et d'une deuxième extrémité d'ensemble, le premier ensemble de transformateur comprenant un premier groupe de composants de noyau de fer empilés, le premier groupe de composants de noyau de fer étant doté d'une première interface (1021) définie au niveau de la première extrémité d'ensemble et d'une deuxième interface (1031) définie au niveau de la deuxième extrémité d'ensemble ;
un second ensemble de transformateur (1012), deux extrémités du second ensemble de transformateur étant dotées d'une troisième extrémité d'ensemble et d'une quatrième extrémité d'ensemble, le second ensemble de transformateur comprenant un second groupe de composants de noyau de fer empilés, le second groupe de composants de noyau de fer étant doté d'une troisième interface (1022) définie au niveau de la troisième extrémité d'ensemble et d'une quatrième interface (1032) définie au niveau de la quatrième extrémité d'ensemble ; et
une pluralité de bobines, la pluralité de bobines comprenant une première bobine (W1), une deuxième bobine (W2), une troisième bobine (W3) et une quatrième bobine (W4),
au moins l'une de la première interface (1021) et de la deuxième interface (1031) étant reliée de manière amovible à au moins l'une de la troisième interface (1022) et de la quatrième interface (1032), de façon à connecter de manière amovible le premier ensemble de transformateur (1011) et le second ensemble de transformateur (1012) ;
ledit premier ensemble de transformateur et ledit second ensemble de transformateur étant conçus de sorte que lorsqu'ils sont reliés l'un à l'autre, le premier groupe de composants de noyau de fer et le second groupe de composants de noyau de fer soient combinés pour former une pluralité de noyaux de fer en forme d'anneau fermé, et au moins deux noyaux de fer en forme d'anneau fermé (221, 222) de la pluralité de noyaux de fer en forme d'anneau fermé étant respectivement enroulés avec l'une de la première bobine (W1) et de la deuxième bobine (W2) ;
une zone fermée étant définie entre le premier ensemble de transformateur et le second ensemble de transformateur de sorte que lorsqu'un câble en cours d'essai (210) passe à travers la zone fermée, un courant induit lié au courant dans le câble en cours d'essai (210) soit généré dans au moins une bobine de la pluralité de bobines ;
ladite quatrième bobine (W4) étant conçue pour générer un courant induit lié au courant dans le câble en cours d'essai lorsque le câble en cours d'essai (210) traverse la zone fermée, **caractérisé en ce que**
les première et deuxième bobines (W1, W2) sont agencées pour déterminer une composante CC du courant induit, et la troisième bobine (W3) est agencée pour déterminer une composante CA du courant induit.

2. Transformateur de courant selon la revendication 1, ladite quatrième bobine (W4) étant enroulée sur l'extérieur de la pluralité de noyaux de fer en forme d'anneau fermé (221, 222, 223).

3. Transformateur de courant selon la revendication 2, ledit premier groupe de composants de noyau de fer comprenant deux composants de noyau de fer, le second groupe de composants de noyau de fer comprenant deux composants de noyau de fer, et lorsque le premier ensemble de transformateur et le second ensemble de transformateur sont reliés l'un à l'autre, lesdits deux composants de noyau de fer du premier groupe de composants de noyau de fer et lesdits deux composants de noyau de fer du second groupe de composants de noyau de fer étant combinés pour former deux noyaux de fer en forme d'anneau fermé (221, 222), chaque noyau de fer en forme d'anneau fermé étant respectivement enroulé avec l'une de la première bobine (W1) et de la deuxième bobine (W2), et l'extérieur des deux noyaux de fer en forme d'anneau fermé étant en outre enroulé avec la troisième bobine (W3) et la quatrième bobine (W4).

4. Transformateur de courant selon la revendication 2, ledit premier groupe de composants de noyau de fer comprenant trois composants de noyau de fer, ledit second groupe de composants de noyau de fer comprenant trois composants de noyau de fer, et lorsque le premier ensemble de transformateur et le second ensemble de transformateur sont reliés l'un à l'autre, lesdits trois composants de noyau de fer du premier groupe de composants de noyau de fer et lesdits trois composants de noyau de fer du second groupe de composants de noyau de fer étant combinés pour former trois noyaux de fer en forme d'anneau fermé (221, 222, 223), chaque noyau de fer en forme d'anneau fermé étant respectivement enroulé avec l'une de la première bobine (W1), de la deuxième bobine (W2) et de la troisième bobine (W3), et l'extérieur des trois noyaux de fer en forme d'anneau fermé étant en outre enroulé avec la quatrième bobine (W4).

5. Transformateur de courant selon la revendication 1, ledit premier groupe de composants de noyau de fer comprenant quatre composants de noyau de fer, ledit second groupe de composants de noyau de fer comprenant quatre composants de noyau de fer, et lorsque le premier ensemble de transformateur et le second ensemble de transformateur sont reliés l'un à l'autre, lesdits quatre composants de noyau de fer du premier groupe de composants de noyau de fer et lesdits quatre composants de noyau de fer du second groupe de composants de noyau de fer étant combinés pour former quatre noyaux de fer en forme d'anneau fermé (221, 222, 223), et chaque noyau de fer en forme d'anneau fermé étant respectivement enroulé avec l'une de la première bobine (W1), de la deuxième bobine (W2), de la troisième bobine (W3) et de la quatrième bobine (W4).

6. Transformateur de courant selon l'une quelconque des revendications 2-4,
ledit premier ensemble de transformateur comprenant en outre un premier boîtier, et ledit premier boîtier étant conçu pour confiner le premier groupe de composants de noyau de fer à l'intérieur de celui-ci ;
ledit second ensemble de transformateur comprenant en outre un second boîtier, et ledit second boîtier étant conçu pour confiner le second groupe de composants de noyau de fer à l'intérieur de celui-ci ; et
ledit premier boîtier et ledit second boîtier étant conçus de sorte que lorsque le premier ensemble de transformateur et le second ensemble de transformateur sont reliés l'un à l'autre, le premier boîtier et le second boîtier soient combinés pour former un boîtier en forme d'anneau fermé de façon à recevoir la pluralité de noyaux de fer en forme d'anneau fermé à l'intérieur de celui-ci, et qu'au moins la quatrième bobine (W4) enroulée sur l'extérieur de la pluralité de noyaux de fer en forme d'anneau fermé soit enroulée sur le boîtier en forme d'anneau fermé.

7. Transformateur de courant selon l'une quelconque des revendications 1-6, au moins l'une de la première interface et de la deuxième interface et au moins l'une de la troisième interface et de la quatrième interface étant dotées de structures entrecroisées, et lesdites structures entrecroisées étant capables d'être reliées les unes aux autres d'une manière entrecroisée lorsque les interfaces sont reliées les unes aux autres, et/ou
chacune de la première interface, de la deuxième interface, de la troisième interface et de la quatrième interface étant dotée d'un élément de guidage pour guider la liaison de l'interface.

8. Transformateur de courant selon la revendication 7, ledit élément de guidage de chaque interface comprenant une pluralité d'éléments de guidage, chaque élément de guidage entourant une extrémité d'un composant de noyau de fer du premier groupe de composants de noyau de fer ou du second groupe de composants de noyau de fer, chaque élément de guidage étant doté d'une partie de saillie et d'une partie d'évidement appariées, et lorsqu'une interface est reliée à une autre interface, une partie de saillie et une partie d'évidement appariées de celle-ci sont appariées avec une partie de saillie et une partie d'évidement appariées d'un élément de guidage de l'autre interface.

9. Transformateur de courant selon l'une quelconque des revendications 1-8, comprenant en outre un ou plusieurs éléments de fixation destinés à fixer le premier ensemble de transformateur et le second ensemble de transformateur ensemble lorsque les interfaces sont reliées l'une à l'autre.

10. Transformateur de courant selon l'une quelconque des revendications 1-9, ladite première interface étant reliée de manière amovible à la troisième interface, et ladite deuxième interface étant reliée de manière amovible à la quatrième interface, et/ou
ledit premier ensemble de transformateur et ledit second ensemble de transformateur présentant une forme d'anneau semi-circulaire.

11. Transformateur de courant selon l'une quelconque des revendications 1-10, au moins deux composants de noyau de fer du premier groupe de composants de noyau de fer étant enroulés avec une première partie de la première bobine et une première partie de la deuxième bobine, et au moins deux composants de noyau de fer du second groupe de composants de noyau de fer étant enroulés avec une seconde partie de la première bobine et une seconde partie de la deuxième bobine, et lorsque le premier ensemble de transformateur et le second ensemble de transformateur sont reliés l'un à l'autre, lesdites première et deuxième bobines respectivement enroulées sur les au moins deux noyaux de fer en forme d'anneau fermé de la pluralité de noyaux de fer en forme d'anneau fermé étant formées par la première partie de la première bobine et la première partie de la deuxième bobine sur au moins deux composants de noyau de fer du premier groupe de composants de noyau de fer reliés à la seconde partie de la première bobine et à la seconde partie de la deuxième bobine sur au moins deux composants de noyau de fer correspondants du second groupe de composants de noyau de fer.

12. Transformateur de courant selon l'une quelconque des revendications 2-11, ledit extérieur du premier groupe de composants de noyau de fer étant enroulé avec une première partie de la quatrième bobine, ledit extérieur du second groupe de composants de noyau de fer étant enroulé avec une seconde partie de la quatrième bobine, et lorsque le premier ensemble de transformateur et le second ensemble de transformateur sont reliés l'un à l'autre, ladite quatrième bobine enroulée sur l'extérieur de la pluralité de noyaux de fer en forme d'anneau fermé étant formée par la première partie de la quatrième bobine enroulée sur l'extérieur du premier groupe de composants de noyau de fer reliés à la seconde partie de la quatrième bobine enroulée sur l'extérieur du second groupe de composants de noyau de fer.

13. Transformateur de courant selon l'une quelconque des revendications 1-12, chacune des première et deuxième bobines enroulées sur chaque composant de noyau de fer du premier groupe de composants de noyau de fer s'étendant respectivement sur toute la longueur à partir de la première extrémité d'ensemble jusqu'à la deuxième extrémité d'ensemble, et/ou chacune des première et deuxième bobines enroulées sur chaque composant de noyau de fer du second groupe de composants de noyau de fer s'étendant respectivement sur toute la longueur à partir de la troisième extrémité d'ensemble jusqu'à la quatrième extrémité d'ensemble.

14. Transformateur de courant selon l'une quelconque des revendications 1-13, au moins un composant de noyau de fer du premier groupe de composants de noyau de fer et du second groupe de composants de noyau de fer étant constitué d'un matériau d'alliage fer-nickel, et/ou ledit extérieur des composants de noyau de fer et des bobines du premier ensemble de transformateur et du second ensemble de transformateur étant doté d'une couche de blindage métallique en vue d'une protection contre un champ électrique externe.

15. Transformateur de courant selon la revendication 14,
ledit premier ensemble de transformateur comprenant en outre un premier boîtier, ledit premier boîtier étant conçu pour confiner le premier groupe de composants de noyau de fer à l'intérieur de celui-ci, et ledit premier boîtier étant logé dans la couche de blindage métallique ; et
ledit second ensemble de transformateur comprenant en outre un second boîtier, ledit second boîtier étant conçu pour confiner le second groupe de composants de noyau de fer à l'intérieur de celui-ci, et ledit second boîtier étant logé dans la couche de blindage métallique.
